# EUROPEAN PATENT APPLICATION

(11) **EP 4 611 014 A1**
(43) Date of publication of application: **03.09.2025**
(21) Application number: 23881667.2
(22) Date of filing: 14.10.2023
(51) Int. Cl.: H01H 1/06

(54) **ELECTRICAL CONTACT CONDUCTOR**

(30) Priority: 28.10.2022 CN 202211336914
(71) Applicant: Zhejiang Chint Electrics Co., Ltd., Yueqing, Zhejiang 325603 (CN)
(72) Inventor: XIANG, Yu, Wenzhou, Zhejiang 325602 (CN); SHEN, Qi, Wenzhou, Zhejiang 325602 (CN); LIN, Juanyu, Wenzhou, Zhejiang 325602 (CN); XU, Zhengli, Wenzhou, Zhejiang 325602 (CN); ZENG, Lang, Wenzhou, Zhejiang 325602 (CN)
(74) Representative: Petraz, Gilberto Luigi
(86) International application number: PCT/CN2023/124632
(87) International publication number: WO 2024/088088

(57) **Abstract**

The present invention provides an electrical contact conductor and relates to the field of electrical appliances. The electrical contact conductor includes a contact conductor and a matching conductor. The contact conductor includes a substrate; a first conductive layer covering the substrate; and a wear-resistant portion, the wear-resistant being connected with the substrate and/or the first conductive layer, and the wear-resistant portion protruding from the surface of the first conductive layer. The electrical contact conductor provided by the present invention has good wear resistance and electrical conductivity.

## Description

### TECHNICAL FIELD

The present invention relates to the technical field of electrical appliances, in particular to an electrical contact conductor.

### BACKGROUND

A main function of the existing electrical contact conductor is to realize power-on or power-off operations through a contact state. Therefore, contact conductors for different purposes usually need to meet the requirement of strong conductivity, which is also the reason why most of electrical contact conductors are silver-plated to enhance the conductivity. Under the premise of satisfying the requirement of strong conductivity, due to the repeated disconnection and contact of the contact conductor, the wear of a contact conductor coating will be caused, so that the contact conductivity of the contact conductor cannot meet the design and practical application requirements. Therefore, the contact conductor also needs to have strong wear resistance, which is also the reason why the contact conductor needs to be tested for the number of wear resistance times before use. It can be seen that in order to better meet the needs of use, the contact conductor should have good wear resistance and conductivity at the same time.

However, under the prior art, it is difficult to meet the wear resistance and electrical conductivity at the same time. For example, in the case that the contact conductor has a silver-graphene electroplated coating, if the wear resistance of the contact conductor is to be enhanced, it is generally necessary to add components (e.g., trace metal elements) to enhance the wear resistance of the electroplated coating. The larger the amount of trace metal elements, and the stronger the wear resistance of the electroplated coating. However, the conductivity of the electroplated coating is also reduced. If the conductivity of the contact conductor is to be enhanced, the silver content in the electroplated coating can be increased, but in this case, the wear resistance and arc burning resistance of the contact conductor will be reduced at the same time.

Therefore, there is an urgent need for a contact conductor with excellent wear resistance and good conductivity.

### SUMMARY

An object of the present invention is to provide an electrical contact conductor, which has good wear resistance and electrical conductivity.

In order to achieve the above object, the present invention adopts the following technical solutions:
The present invention provides an electrical contact conductor, comprising a contact conductor and a matching conductor, wherein the contact conductor comprises:
a substrate;
a first conductive layer covering the substrate; and
a wear-resistant portion, the wear-resistant portion being connected with the substrate and/or the first conductive layer, and the wear-resistant portion protruding from the surface of the first conductive layer.

Optionally, in some embodiments of the present invention, the wear-resistant portion comprises a protrusion body, a second conductive layer and a wear-resistant layer which are arranged in sequence, and the protrusion body is connected with the substrate and protrudes from the surface of the substrate.

Optionally, in some embodiments of the present invention, the protrusion body and the substrate are formed integrally; or
the protrusion body is connected with the substrate by means of clamping, riveting or welding.

Optionally, in some embodiments of the present invention, the wear-resistant portion comprises a second conductive layer and a wear-resistant layer which are arranged in sequence; the second conductive layer is arranged on one side of the wear-resistant layer close to the substrate; and the sum of the thickness of the second conductive layer and the thickness of the wear-resistant layer is greater than the thickness of the first conductive layer.

Optionally, in some embodiments of the present invention, the thickness of the second conductive layer is different from that of the first conductive layer, and the second conductive layer protrudes from the surface of the first conductive layer; or
the thickness of the second conductive layer is the same as that of the first conductive layer, and the wear-resistant layer protrudes from the surface of the first conductive layer.

Optionally, in some embodiments of the present invention, materials for the first conductive layer and the second conductive layer both comprise silver and graphene; and materials for the wear-resistant layer comprise graphene and trace metal element or a metal compound.

Optionally, in some embodiments of the present invention, the graphene in the materials of the first conductive layer has a mass fraction of 1.5-3.0%; the graphene in the materials of the second conductive layer has a mass fraction of 1.5-3.0%; the trace metal element in the materials of the wear-resistant layer has a mass fraction of 0.3-0.8%; and/or
the trace metal element or metal compound is selected from one or more of nickel, palladium, cobalt, titanium, vanadium, cadmium, chromium, manganese, tin, antimony, tungsten, bismuth, yttrium, zirconium, iridium, niobium, molybdenum, ruthenium, scandium, rhodium, indium, pickaxe, lanthanide, tungsten carbide, and rare earth oxide.

Optionally, in some embodiments of the present invention, the trace metal element is nickel, and the wear-resistant layer is a nickel-graphene coating.

Optionally, in some embodiments of the present invention, the second conductive layer has a thickness of 3-20µm, and the wear-resistant layer has a thickness of 1-25µm.

Optionally, in some embodiments of the present invention, the wear-resistant portion has an arc-shaped curved surface, and the arc-shaped curved surface protrudes in a direction away from the substrate; and/or
a protruding height of the wear-resistant portion is 10-60µm.

Optionally, in some embodiments of the present invention, the number of wear-resistant portions is two, and the two wear-resistant portions are respectively arranged on both opposite sides of the substrate.

Optionally, in some embodiments of the present invention, the wear-resistant portions are in contact with the matching conductor before the contact conductor begins to contact the matching conductor; or
the wear-resistant portion are in contact with the matching conductor before the contact conductor is disengaged from the matching conductor.

Optionally, in some embodiments of the present invention, the matching conductor comprises a main body and at least two elastic portions connected by the main body; and
the contact conductor can be placed between the at least two elastic portions and is in contact with the at least two elastic portions.

Optionally, in some embodiments of the present invention, the substrate of the contact conductor comprises a first segment and a second segment connected with the first segment, the second segment is a conical body, and the wear-resistant portion is arranged in the second segment;
under the condition that the contact conductor is docked with the matching conductor, the wear-resistant portion supports the elastic portions; and
under the condition that the contact conductor is docked with the matching conductor, the first segment is clamped by the elastic portions.

Optionally, in some embodiments of the present invention, the electrical contact conductor is a switch device, the contact conductor is a moving contact, and the matching conductor is a static contact.

The contact conductor of the present invention is provided with a wear-resistant portion that protrudes on the surface of a body. When the contact conductor is in contact with a matching conductor, a corresponding position of the wear-resistant portion first contacts the matching conductor. Therefore, the friction between the contact conductor and the matching conductor is mainly borne by the wear-resistant portion. That is, the wear of the contact conductor is mainly concentrated in the wear-resistant portion with good wear resistance, so that the wear of a conductive layer is effectively reduced or even avoided. Meanwhile, the good conductivity of the conductive layer makes the contact conductor also have better conductivity. In addition, because the protruding wear-resistant portion is arranged in this scheme, the protruding structure makes the contact conductor have a larger contact area under the condition that the contact conductor is docked with the matching conductor, so that the conductivity of the contact conductor is further improved.

In summary, the present invention solves the problem that the wear resistance and electrical conductivity of the contact conductor in the prior art are difficult to improve at the same time, and through the design and cooperation of the protruding wear-resistant portion and the conductive layer, the contact conductor provided by the present invention has excellent wear resistance and better conductivity at the same time.

### BRIEF DESCRIPTION OF THE DRAWINGS

To describe the technical solutions in the embodiments of the present invention more clearly, the following briefly introduces the accompanying drawings required for describing the embodiments. Apparently, the accompanying drawings in the following description show merely some embodiments of the present invention, and a person of ordinary skill in the art may still derive other drawings from these accompanying drawings without creative efforts.
FIG. 1 is a sectional view of a contact conductor provided by Embodiment 1 of the present invention;
FIG. 2 is a schematic diagram in which the contact conductor provided by Embodiment 1 of the present invention is clamped between two elastic portions;
FIG. 3 is a sectional view of a contact conductor provided by Embodiment 2 of the present invention;
FIG. 4 is a schematic diagram in which a wear-resistant portion of the contact conductor provided by Embodiment 2 of the present invention supports an elastic portion of a matching conductor;
FIG. 5 is a schematic diagram in which the contact conductor is clamped by two elastic portions of the matching conductor provided by Embodiment 2 of the present invention;
FIG. 6 is a sectional view of a contact conductor provided by Embodiment 3 of the present invention;
FIG. 7 is a sectional view of the contact conductor provided by Embodiment 3 of the present invention; and
FIG. 8 is a sectional view of a contact conductor provided by Embodiment 4 of the present invention.

The reference numerals are summarized as follows:
10-contact conductor; 101-substrate; 1001-first segment; 1002-second segment; 102-first conductive layer; 103-wear-resistant portion; 1031-protrusion; 1032-second conductive layer; 1033-wear-resistant layer; 11-matching conductor; 111-main body; and 112-elastic portion.

### DETAILED DESCRIPTION OF THE INVENTION

The technical solutions in the embodiments of the present invention will be clearly and completely described as follows in combination with the drawings in the examples of the present invention, but obviously, the described examples are only a part of the embodiments of the present invention, rather than all the embodiments. Based on the examples of the present invention, all other examples obtained by a person skilled in the art without creative efforts shall fall within the protection scope of the present invention.

The technical solution provided by the present invention will be described in detail below. It should be noted that the description order of the following embodiments is not intended to limit the priority order of the embodiments. In addition, in the description of the present invention, the term "including" means "including but not limited to". The terms "first", "second", etc., are used only as indications and do not impose numerical requirements or establish sequences. Various embodiments of the present invention may exist in the form of a scope. It should be understood that the description in the form of a scope is only for convenience and conciseness, and should not be construed as a rigid limitation on the scope of the present invention. Therefore, the scope description should be considered to have specifically disclosed all possible sub-scopes as well as a single value within this scope.

The present invention provides an electrical contact conductor. The electrical contact conductor includes a contact conductor and a matching conductor, wherein the contact conductor includes:
a substrate;
a first conductive layer covering the substrate; and
a wear-resistant portion, the wear-resistant portion being connected with the substrate and/or the first conductive layer, and the wear-resistant portion protruding from the surface of the first conductive layer.

The electrical contact conductor in the present invention refers to a conductor that can be applied to electrical contact, including but not limited to a switch contact, a contact point, etc. Further, the electrical contact conductor may also be called a contact wire, etc., which, however, is in the same range as the electrical contact conductor in the present invention.

Based on a height difference between the wear-resistant layer and the first conductive layer brought about by the arrangement of the protruding wear-resistant portion, the corresponding position of the protruding wear-resistant portion first contacts the matching conductor. Therefore, the friction between the contact conductor and the matching conductor is mainly borne by the wear-resistant portion. That is, the wear of the contact conductor is mainly concentrated in the wear-resistant portion with good wear resistance, so that the wear of the first conductive layer is effectively reduced or even avoided. However, based on the good conductivity of the first conductive layer, the contact conductor in the present invention also has better conductivity. In addition, the protruding wear-resistant portion is arranged such that the contact area of the electrical contact conductor is increased, thereby further improving the conductivity of the contact conductor.

The wear-resistant portion is connected with the substrate and/or the first conductive layer, and the wear-resistant portion protrudes from the surface of the first conductive layer, that is, the wear-resistant portion covers the surface of the substrate.

Specifically, the substrate may be divided into a base body and a connecting body. The base body and the connecting body only involve the division of different areas of the substrate. At this time, the first conductive layer may cover the base body, and the wear-resistant portion is connected with the connecting body. Further, the wear-resistant portion can realize the connection between the wear-resistant portion and the connecting body in the way of covering the connecting body. Meanwhile, the wear-resistant portion may be connected with the first conductive layer, and at this time, the surface of the substrate is completely covered by the first conductive layer and the wear-resistant portion.

In some embodiments, the wear-resistant portion may include a wear-resistant layer, a conductive layer and other film layers. The wear-resistant portion protruding from the first conductive layer may be caused by the connecting body protruding from the surface of the base body or may be caused by a difference between the thickness of a film layer arranged on the surface of the connecting body and the thickness of the first conductive layer arranged on the surface of the base body, as long as the wear-resistant portion can protrude from the surface of the first conductive layer, which will not be repeated herein.

Specifically, the wear-resistant portion includes a protrusion body, a second conductive layer and a wear-resistant layer which are arranged in sequence, wherein the protrusion body is connected with the substrate and protrudes from the surface of the substrate. The second conductive layer covers the surface of the protrusion body, and the wear-resistant layer covers the surface of the second conductive layer. It is may be understood that at this time, the arrangement of the protrusion body is one of the factors that realize the protrusion of the wear-resistant portion. Further, if the sum of the thickness of the wear-resistant layer and the thickness of the second conductive layer is greater than the thickness of the first conductive layer, the protruding degree of the wear-resistant portion can be further increased.

In some embodiments, the protrusion body and the substrate may be formed integrally. At the same time, the materials for the protrusion body may be the same as those of the substrate. In some embodiments, the protrusion body may be connected with the substrate by means of clamping, riveting or welding. At this time, the materials for the protrusion body and the materials for the substrate may be the same or different, which will not be repeated herein.

In some embodiments, the first conductive layer and the second conductive layer may be formed integrally. At this time, the materials for the first conductive layer and the materials for the second conductive layer may be the same. Further, the first conductive layer and the second conductive layer may also be prepared separately. At this time, the materials for the first conductive layers and the materials for the second conductive layer may be the same or different, which will not be repeated herein.

In some embodiments, the materials for the first conductive layer and the materials for the second conductive layer may be different, but the materials for the second conductive layer and the materials for the wear-resistant layer may be the same. At this time, the second conductive layer and the wear-resistant layer may be formed integrally or separately, which will not be repeated herein. When the materials for the second conductive layer and the materials for the wear-resistant layer are the same, it can be regarded as the wear-resistant portion being actually the wear-resistant layer.

In some embodiments, the wear-resistant portion includes a second conductive layer and a wear-resistant layer which are arranged in sequence; the second conductive layer is arranged on one side of the wear-resistant layer close to the substrate; and the sum of the thickness of the second conductive layer and the thickness of the wear-resistant layer is greater than the thickness of the first conductive layer. It may be understood that at this time, the protrusion of the wear-resistant portion is realized due to a difference between the sum of the film layer thickness of the second conductive layer and the film layer thickness of the wear-resistant layer and the film layer thickness of the first conductive layer, and the protrusion of the wear-resistant portion is actually the protrusion of a wear-resistant coating.

In some embodiments, the thickness of the first conductive layer may be the same as that of the second conductive layer, and the thickness of the first conductive layer may also be different from that of the second conductive layer.

Further, the thickness of the second conductive layer is different from that of the first conductive layer, and the second conductive layer protrudes from the surface of the first conductive layer. It may be understood that the protrusion of the wear-resistant portion at this time is achieved by the difference in thickness between the first conductive layer and the second conductive layer.

Correspondingly, in some embodiments, the thickness of the second conductive layer is the same as that of the first conductive layer, and the wear-resistant layer protrudes from the surface of the first conductive layer. It may be understood that the protrusion of the wear-resistant portion at this time is achieved by the thickness of the wear-resistant layer.

In some embodiments, the materials for the first conductive layer and the materials for the second conductive layer both include silver and graphene, and the materials for the wear-resistant layer include graphene and trace metal element or a metal compound. In this way, the wear resistance of the wear-resistant layer is improved.

The graphene has many advantages such as high electrical conductivity, high thermal conductivity, high strength, high flexibility, strong chemical inertness and excellent gas barrier performance, and the existence of the graphene can improve the comprehensive properties of the conductive layers and the wear-resistant layer. In some embodiments, when the first conductive layer and the second conductive layer are formed, graphene and a metal salt may be mixed into the same plating solution for electroplating, and the conductive layer of graphene and electroplated metal is formed on the surface of the contact conductor.

In some embodiments, the graphene in the materials of the first conductive layer has a mass fraction of 1.5-3.0%; the graphene in the materials of the second conductive layer has a mass fraction of 1.5-3.0%; and the trace metal element in the materials of the wear-resistant layer has a mass fraction of 0.3-0.8%.

In some embodiments, the trace metal element or metal compound is selected from one or more of nickel, palladium, cobalt, titanium, vanadium, cadmium, chromium, manganese, tin, antimony, tungsten, bismuth, yttrium, zirconium, iridium, niobium, molybdenum, ruthenium, scandium, rhodium, indium, pickaxe, lanthanide, tungsten carbide, and rare earth oxide.

Preferably, the trace metal element is nickel, and the wear-resistant layer is a nickel-graphene coating.

In some embodiments, the conductive layer has a thickness of 3-20µm, and the wear-resistant layer has a thickness of 1-25µm.

In some embodiments, the wear-resistant portion has an arc-shaped curved surface which protrudes in a direction away from the substrate.

In some embodiments, the wear-resistant portion may also be a triangular protrusion, a rectangular protrusion, etc., which will not be limited herein.

In some embodiments, a protruding height of the wear-resistant portion is 10-60µm.

In some embodiments, the contact conductor may include a wear-resistant portion. At this time, the wear-resistant portion may be an independent protruding wear-resistant portion or a circle of protruding wear-resistant portion that surrounds the contact conductor, which will not be limited herein.

In some embodiments, the contact conductor may include a plurality of wear-resistant portions. At this time, the plurality of wear-resistant portions may be spaced from each other. In some embodiments, the number of wear-resistant portions may be 2, and the number of wear-resistant portions may also be 3 or 4, which will not be repeated herein.

In some embodiments, the number of wear-resistant portions may be two, and the two wear-resistant portions are respectively arranged on both opposite sides of the substrate.

In some embodiments, the wear-resistant portion is in contact with the matching conductor before the contact conductor begins to contact the matching conductor; or the wear-resistant portion is in contact with the matching conductor before the contact conductor is disengaged from the matching conductor. In this way, the friction between the contact conductor and the matching conductor can be concentrated in the wear-resistant portion of the contact conductor, and the wear of the contact conductor is reduced.

In some embodiments, the matching conductor includes a main body and at least two elastic portions connected by the main body.

The contact conductor can be placed between the at least two elastic portions and is in contact with the at least two elastic portions.

Further, in the case that the contact conductor is docked with the matching conductor, the wear-resistant portions of the contact conductor support at least one elastic portion, and the contact conductor is clamped between the at least two elastic portions so as to complete the docking between the contact conductor and the matching conductor.

It should be noted that the support here refers to the fact that because a gap between the elastic portions of the matching conductor is smaller than the size of the electrical contact conductor, the contact conductor is squeezed into the elastic portions in the docking process between the contact conductor and the matching conductor, and the protruding wear-resistant portion of the contact conductor will push the elastic portions outward, so that the gap between the elastic portions becomes larger, so as to complete the docking between the matching conductor and the contact conductor. **In** some embodiments, the docking may refer to the insertion of the contact conductor into the matching conductor.

Further, under the condition that the contact conductor is docked with the matching conductor, the wear-resistant portions of the contact conductor support at least one elastic portion of the matching conductor, and the contact conductor is clamped between the at least two elastic portions.

Through the above method, in the docking process between the contact conductor and the matching conductor, the friction of the matching conductor on the conductive layer of the contact conductor in the docking process is reduced or even avoided due to the supporting of the protruding wear-resistant portions, and the wear of the contact conductor is concentrated in the wear-resistant layer with good wear resistance, thereby reducing the wear of the contact conductor.

In the case that the contact conductor is clamped by the elastic portions, in order to make the contact between the contact conductor and the elastic portions more stable, a clamping device may also be arranged on the matching conductor. When the contact conductor is clamped between the elastic portions, the elastic portion is clamped from the outer side of the elastic portion away from the contact conductor, so that the clamping stability between the elastic portion and the contact conductor is increased. Alternatively, an external clamping device may also be used to clamp the elastic portions of the matching conductor and the contact conductor.

In some embodiments, according to actual needs, the number of the elastic portions may be 2, or the number of the elastic portions may also be 3 or 4, which will not be repeated herein.

In some embodiments, the substrate of the contact conductor includes a first segment and a second segment connected with the first segment, wherein the second segment is a conical body, and the wear-resistant portion is arranged in the second segment.

Under the condition that the contact conductor is docked with the matching conductor, the wear-resistant portion supports the elastic portions.

Under the condition that the contact conductor has been docked with the matching conductor, the first segment is clamped by the elastic portions.

The first segment and the second segment of the body may be formed integrally, or formed separately and then connected. It should be noted that the second segment is a conical body. The conical body, in a broad sense, is within the protection scope as long as it has a structure similar to the gradual reduction of size.

In some embodiments, the space between the elastic portions for accommodating the contact conductor may correspond to the shape of the contact conductor.

In some embodiments, the electrical contact conductor is a switch, the contact conductor is a moving contact, and the matching conductor is a static contact. The above-mentioned moving contact refers to a contact that moves during operation (docking). The static contact refers to a contact when the switch, the relay and the contactor do not act with an execution mechanism. In some embodiments, the static contact may also be called a static contact point.

### Embodiment 1

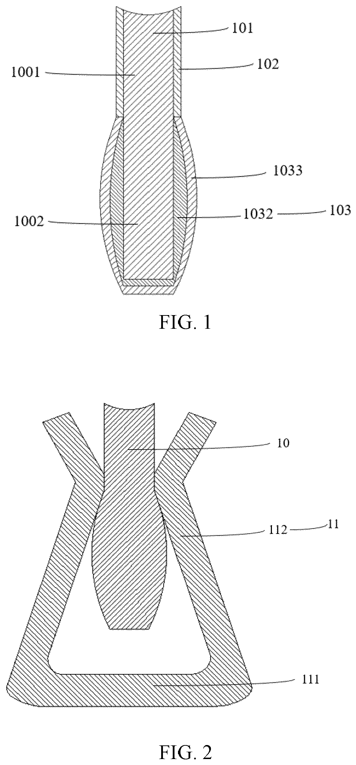

The present embodiment provides an electrical contact conductor, including a contact conductor 10 and a matching conductor 11, wherein a sectional view of the contact conductor 10 is shown in FIG. 1.

The electrical contact conductor 10 includes:
a substrate 101, the substrate 101 including a first segment 1001 and a second segment 1002 connected with the first segment 1001, and the second segment 1002 being a conical body;
a first conductive layer 102 covering the substrate 101, the first conductive layer 102 having a thickness of 20µm;
a wear-resistant portion 103, including a protrusion body 1031, a second conductive layer 1032 and a wear-resistant layer 1033 which are arranged in sequence, wherein the protrusion body 1031 has an arc-shaped curved surface, a direct vertical distance between a vertex of the arc-shaped curved surface and the surface of the body 1011 is 60µm, the second conductive layer 1032 has a thickness of 20µm, and the wear-resistant layer has a thickness of 25µm; the wear-resistant portion 103 is connected with the substrate 101, and the wear-resistant portion 103 is connected with the first conductive layer 102; the wear-resistant portion 103 protrudes from the surface of the first conductive layer 102; and
a matching conductor 11, comprising a main body 111 and two elastic portions 112 connected to the main body 111, wherein an insertion portion for the contact conductor 10 to enter the matching conductor 11 and an accommodating portion accommodating the contact conductor 10 are sequentially arranged between the elastic portions 112; and
in the case that the contact conductor 10 is docked with the matching conductor 11, the wear-resistant portion 103 of the contact conductor 10 supports the two elastic portions 112, and the contact conductor 10 is clamped between the two elastic portions 112 so as to complete the insertion and docking of the contact conductor 10 and the matching conductor 11.

The contact conductor 10 is a moving contact, and the matching conductor 11 is a static contact.

A schematic diagram in which the contact conductor 10 is clamped between the two elastic portions 112 is shown in FIG. 2.

### Embodiment 2

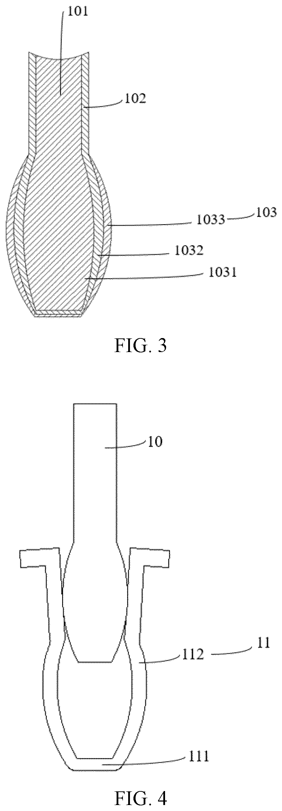

The present embodiment provides an electrical contact conductor, including a contact conductor 10 and a matching conductor 11, wherein a sectional view of the contact conductor 10 is shown in FIG. 3. The contact conductor 10 includes:
a substrate 101;
a first conductive layer 102 covering the substrate 101, the first conductive layer 102 having a thickness of 3µm;
a wear-resistant portion 103, including a protrusion body 1031, a second conductive layer 1032 and a wear-resistant layer 1033 which are arranged in sequence, wherein the protrusion body 1031 has an arc-shaped curved surface, a direct vertical distance between a vertex of the arc-shaped curved surface and the surface of the body 1011 is 10µm, the protrusion body 1031 and the substrate 101 are formed integrally, the second conductive layer 1032 has a thickness of 3µm, and the wear-resistant layer has a thickness of 1µm; the wear-resistant portion 103 is connected with the substrate 101, and the wear-resistant portion 103 is connected with the first conductive layer 102; the wear-resistant portion 103 protrudes from the surface of the first conductive layer 102; and
a matching conductor 11 including a main body 111 and at least two elastic portions 112 connected through the main body 111; and
in the case that the contact conductor 10 is docked with the matching conductor 11, the wear-resistant portion 103 of the contact conductor 10 supports the two elastic portions 112, and the contact conductor 10 is clamped between the two elastic portions 112 so as to complete the insertion and docking of the contact conductor 10 and the matching conductor 11.

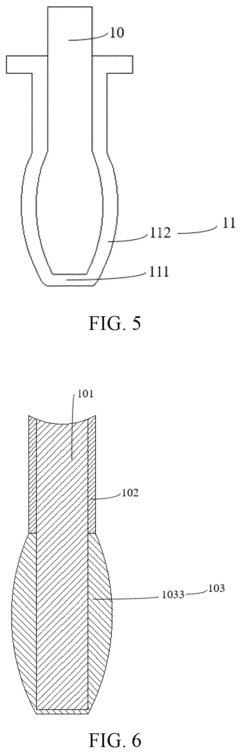

In the docking process, a schematic diagram in which the wear-resistant portion 103 of the contact conductor 10 supports the two elastic portions 112 is shown in FIG. 4, and a schematic diagram in which the contact conductor 10 is clamped by the two elastic portions 112 is shown in FIG. 5.

### Embodiment 3

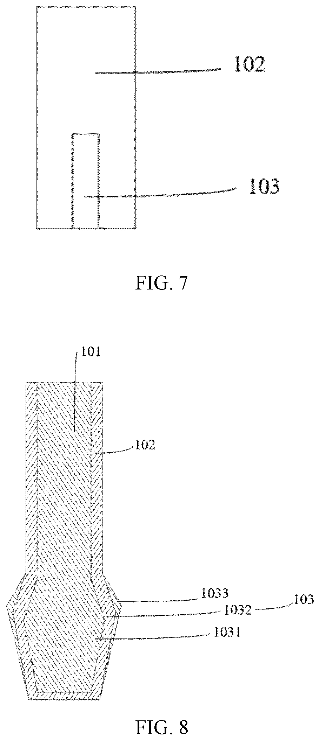

The present embodiment provides an electrical contact conductor 10. A sectional view of the contact conductor 10 is shown in FIG. 6, and a side view of the contact conductor is shown in FIG. 7. The contact conductor 10 includes:
a substrate 101;
a first conductive layer 102 covering the substrate 101, the first conductive layer 102 having a thickness of 3 µm; and
wear-resistant portions 103 each including a wear-resistant layer 1033, wherein the wear-resistant layer has a thickness of 25µm; the wear-resistant portion 103 is connected with the substrate 101, and the wear-resistant portion 103 is connected with the first conductive layer 102; the wear-resistant portion 103 protrudes from the surface of the first conductive layer 102; the number of the wear-resistant portions 103 is two, and the two wear-resistant portions 103 are respectively arranged on both opposite sides of the substrate 101.

### Embodiment 4

The present embodiment provides an electrical contact conductor 10. A sectional view of the contact conductor 10 is shown in FIG. 8. The contact conductor 10 includes:
a substrate 101;
a first conductive layer 102 covering the substrate 101, the first conductive layer 102 having a thickness of 10µm; and
a wear-resistant portion 103, including a protrusion body 1031, a second conductive layer 1032 and a wear-resistant layer 1033 which are arranged in sequence, wherein the protrusion body 1031 has an triangular shape, a direct vertical distance between a vertex of the triangle and the surface of the body 1011 is 30µm, the protrusion body 1031 and the substrate 101 are formed integrally, the second conductive layer 1032 has a thickness of 10µm, and the wear-resistant layer has a thickness of 20µm; the wear-resistant portion 103 is connected with the substrate 101, the wear-resistant portion 103 is connected with the first conductive layer 102, and the wear-resistant portion 103 protrudes from the surface of the first conductive layer 102; the number of the wear-resistant portions 103 is two, and the two wear-resistant portions 103 are respectively arranged on both opposite sides of the substrate 101.

The technical solution provided by the embodiments of the present application are introduced above in detail. Specific examples are used herein to illustrate the principles and embodiments of the present application. The description of the above embodiments is only used to help the understanding of the methods and core ideas of the present application. At the same time, for those skill in the art, according to the ideas of the present application, there will be changes in the specific embodiments and the scope of application. In summary, the content of the present description should not be construed as a limitation of the present invention.

## Claims

1. An electrical contact conductor, comprising a contact conductor and a matching conductor, wherein the contact conductor comprises:
a substrate;
a first conductive layer covering the substrate; and
a wear-resistant portion, the wear-resistant portion being connected with the substrate and/or the first conductive layer, and the wear-resistant portion protruding from the surface of the first conductive layer.

2. The electrical contact conductor according to claim 1, wherein the wear-resistant portion comprises a protrusion body, a second conductive layer and a wear-resistant layer which are arranged in sequence, and the protrusion body is connected with the substrate and protrudes from the surface of the substrate.

3. The electrical contact conductor according to claim 2, wherein the protrusion body and the substrate are formed integrally; or
the protrusion body is connected with the substrate by means of clamping, riveting or welding.

4. The electrical contact conductor according to claim 1, wherein the wear-resistant portion comprises a second conductive layer and a wear-resistant layer which are arranged in sequence; the second conductive layer is arranged on one side of the wear-resistant layer close to the substrate; and the sum of the thickness of the second conductive layer and the thickness of the wear-resistant layer is greater than the thickness of the first conductive layer.

5. The electrical contact conductor according to claim 4, wherein the thickness of the second conductive layer is different from that of the first conductive layer, and the second conductive layer protrudes from the surface of the first conductive layer; or
the thickness of the second conductive layer is the same as that of the first conductive layer, and the wear-resistant layer protrudes from the surface of the first conductive layer.

6. The electrical contact conductor according to any one of claims 2 to 5, wherein materials for the first conductive layer and the second conductive layer both comprise silver and graphene; and materials for the wear-resistant layer comprise graphene and trace metal element or a metal compound.

7. The electrical contact conductor according to claim 6, wherein the graphene in the materials of the first conductive layer has a mass fraction of 1.5-3.0%; the graphene in the materials of the second conductive layer has a mass fraction of 1.5-3.0%; the trace metal element in the materials of the wear-resistant layer has a mass fraction of 0.3-0.8%; and/or
the trace metal element or metal compound is selected from one or more of nickel, palladium, cobalt, titanium, vanadium, cadmium, chromium, manganese, tin, antimony, tungsten, bismuth, yttrium, zirconium, iridium, niobium, molybdenum, ruthenium, scandium, rhodium, indium, pickaxe, lanthanide, tungsten carbide, and rare earth oxide.

8. The electrical contact conductor according to claim 7, wherein the trace metal element is nickel, and the wear-resistant layer is a nickel-graphene coating.

9. The electrical contact conductor according to any one of claims 2 to 5, wherein the second conductive layer has a thickness of 3-20µm, and the wear-resistant layer has a thickness of 1-25µm.

10. The electrical contact conductor according to claim 1, wherein the wear-resistant portion has an arc-shaped curved surface, and the arc-shaped curved surface protrudes in a direction away from the substrate; and/or
a protruding height of the wear-resistant portion is 10-60µm.

11. The electrical contact conductor according to claim 1, wherein the number of wear-resistant portions is two, and the two wear-resistant portions are respectively arranged on both opposite sides of the substrate.

12. The electrical contact conductor according to claim 1, wherein the wear-resistant portions are in contact with the matching conductor before the contact conductor begins to contact the matching conductor; or
the wear-resistant portion are in contact with the matching conductor before the contact conductor is disengaged from the matching conductor.

13. The electrical contact conductor according to claim 1, wherein the matching conductor comprises a main body and at least two elastic portions connected by the main body; and
the contact conductor can be placed between the at least two elastic portions and is in contact with the at least two elastic portions.

14. The electrical contact conductor according to claim 13, wherein the substrate of the contact conductor comprises a first segment and a second segment connected with the first segment, the second segment is a conical body, and the wear-resistant portion is arranged in the second segment;
under the condition that the contact conductor is docked with the matching conductor, the wear-resistant portion supports the elastic portions; and
under the condition that the contact conductor is docked with the matching conductor, the first segment is clamped by the elastic portions.

15. The electrical contact conductor according to claim 1, wherein the contact conductor is a moving contact, and the matching conductor is a static contact.
